# EUROPÄISCHE PATENTSCHRIFT

(11) **EP 1 967 938 B1**
(45) Veröffentlichungstag und Bekanntmachung des Hinweises auf die Patenterteilung: **29.07.2009**
(21) Anmeldenummer: 07001356.0
(22) Anmeldetag: 23.01.2007
(51) Int. Cl.: G06F 1/20, H05K 7/20

(54) **Schaltschrank zur Aufnahme elektronischer Steckbaugruppen mit einem Wärmetauscher**
Control cabinet for electronic plug-in components with a heat exchanger
Armoire électrique destinée à la réception de modules enfichables électroniques dotée d'un échangeur thermique

(43) Veröffentlichungstag der Anmeldung: 10.09.2008
(73) Patentinhaber: Schroff GmbH, D-75334 Straubenhardt (DE)
(72) Erfinder: Mazura, Paul, 76307 Karlsbad (DE); Pawlowski, Adam, 76337 Waldbronn-Reichenbach (DE)
(74) Vertreter: Petirsch, Markus

(56) Entgegenhaltungen:
- DE-U1-2202004 016 49
- FR-A1- 2 568 712
- JP-A- 8 125 372
- US-A1- 2005 250 435

## Beschreibung

Die vorliegende Erfindung betrifft einen Schaltschrank zur Aufnahme elektronischer Steckbaugruppen mit einem Wärmetauscher.

Schaltschränke werden typischerweise mit einer Reihe von Steckbaugruppen bestückt, die in mehreren Lagen übereinander angeordnet sind. Die Steckbaugruppen werden in dafür vorgesehene Führungsschienen eingeschoben und sind vertikal ausgerichtet. Die benachbarten Steckbaugruppen sind so voneinander beabstandet, dass die von ihnen erzeugte Wärme an die Umgebung der Steckbaugruppen abgegeben werden kann. Die abgegebene Wärme wird durch Luft, die zwischen den Baugruppen zirkuliert, abgeführt.

Auf Grund der steigenden Leistungen der Elektronik und der immer höheren Taktraten sowie des Einsatzes von Hochleistungsprozessoren auf die Steckbaugruppen steigt die Abwärme der einzelnen Baugruppen. Aus diesem Grund reicht das Perforieren der Türen und/oder Seitenwände sowie des Bodens und des Daches der Schränke nicht mehr aus, um die erzeugte Abwärme abzuführen. Insbesondere für bestimmte Anwendungen, bei denen es auf eine elektrische Dichtigkeit des Schaltschranks sowie auf dessen Schirmwirkung und Schirmungseigenschaften besonders ankommt, werden die Schränke mit einer geschlossenen Hülle versehen. Eine Wärmeabgabe an die Umgebung des Schaltschranks ist nicht möglich. Aus diesem Grund werden Kühlsysteme mit einer Luftzirkulation vorgesehen, die die erzeugte Wärme mit Lüftern, die in den Seitenwänden oder im Dach bzw. im Boden des Schaltschranks angeordnet sind, abführen sollen.

Im Einzelfall kann auch eine Flüssigkeitskühlung eingesetzt werden. Hierbei werden einzelne Baugruppen mit Kühlmodulen bestückt, die an einen Flüssigkeitskühlkreislauf angeschlossen sind. Derartige Steckbaugruppen sind beispielsweise aus der DE 20 2004 010 204.8 bekannt.

Darüber hinaus werden Schaltschränke auch mit Wärmetauschern versehen, mit denen die Luft gekühlt wird. Die von den einzelnen Steckbaugruppen erzeugte Abwärme wird dann durch den Wärmetauscher geführt und von diesen gekühlt, so dass sich ein geschlossener Kühlkreislauf realisieren lässt. Der Wärmetauscher kann beispielsweise als Luft-Wasser-Wärmetauscher ausgebildet sein, der mit Kühlwasser gespeist wird. Die bekannten Wärmetauscher und Luft-Wasser-Wärmetauscher werden auf dem Dach der Schaltschränke oder im Außenbereich einer Seitenwand sowie an der rückwärtigen Tür montiert. Teilweise sind sie auch als Einschub im unteren Bereich des Schaltschranks realisiert.

Bei Anordnung der Wärmetauscher an der Seitenwand können jedoch nicht mehrere Schaltschränke nebeneinander oder nur noch eingeschränkt nebeneinander angeordnet werden. Der zur Verfügung stehende Aufstellungsraum für die Schränke wird daher nicht optimal genutzt. Eine Anordnung des Wärmetauschers auf dem Dach des Schranks kann bei Luft-Wasser-Wärmetauschern durch einen Wasseraustritt oder durch heruntertropfendes Kondenswasser zu einer Beschädigung der elektronischen Steckbaugruppen führen.

Um die Gefahr einer Beschädigung der elektronischen Steckbaugruppen durch Tropfwasser zu verhindern, werden die Wärmetauscher unterhalb bzw. im Sockel des Schaltschranks angeordnet. Ein derartiger Schaltschrank mit einem Luft-Wasser-Wärmetauscher, der im Sockel angeordnet ist, ist aus der japanischen Druckschrift JP08125372A bekannt. In dem vorgeschlagenen Schaltschrank sind zwei Wärmetauscher im Sockel angeordnet, die jeweils mit einem Lüfter kombiniert sind. Ein Teil der vom Wärmetauscher erzeugten Kühlluft wir mit der über einen Luftkanal vom Dach des Schaltschranks zugeführten Warmluft vermischt, bevor die Mischluft dem Wärmetauscher zugeführt wird. Der andere Teil der Kühlluft wird dem Schaltschrank direkt zur Kühlung der elektronischen Baugruppen zugeführt. Um den Luftstrom innerhalb des Schaltschranks zu verbessern, ist etwa in der Mitte des Schaltschranks zwischen zwei übereinander liegenden Baugruppenebenen ein Lüfter vorgesehen, der den vertikalen Luftstrom zum Dach des Schaltschranks unterstützt.

Die aus Wärmetauscher und Lüfter bestehende Kühleinheit ist sehr aufwändig. Sie soll ein Vereisen der Wärmetauschereinheit vermeiden. Die Luftführung innerhalb des Schaltschranks wird jedoch verschlechtert, da ein Teil des Luftstroms wieder zum Lufteinlass des Wärmetauschers umgelenkt wird. Dies soll durch den mittig im Inneren des Schranks angeordneten Lüfter kompensiert werden. Im Servicefall ist ein Austausch des im Innern angeordneten Lüfters schwierig, da der Bereich mit den elektronischen Baugruppen geöffnet werden muss, was regelmäßig zu einem Abschalten der elektronischen Einheiten führt.

Es ist somit Aufgabe der vorliegenden Erfindung, einen Schaltschrank für elektronische Baugruppen mit einem Wärmetauscher zu schaffen, bei dem Beschädigungen der Baugruppen durch Tropfwasser ausgeschlossen werden.

Gelöst wird die vorliegende Aufgabe durch einen Schaltschrank mit den Merkmalen des Anspruchs 1.

Der erfindungsgemäße Schaltschrank zur Aufnahme elektronischer Steckbaugruppen umfasst einen Innenraum, in dem die Wärme erzeugenden Steckbaugruppen übereinander gelagert sind, einen Dachraum, der oberhalb des Innenraums angeordnet und einen Sockel, der unterhalb des Innenraums einen Sockelraum bildet, welcher mit dem Innenraum in Verbindung steht. Der Innenraum und der Sockelraum werden durch einen Boden des Innenraums getrennt, wobei der Boden eine Öffnung aufweist, durch die die beiden Räume durchströmt werden können. Wenigstens ein Luftkanal, der seitlich des Innenraums angeordnet ist, verbindet den Dachraum mit dem Sockelraum. In den Dachraum ist ein Lüfter angeordnet, der Luft aus dem Innenraum angesaugt und durch den Luftkanal in den Sockelraum bläst. Ein Wärmetauscher im Sockelraum des Schranks wird von der erwärmten Luft, die aus dem Luftkanal in den Sockelraum einströmt, derart umströmt, dass die Luft im Wärmetauscher abgekühlt wird. Die erzeugte Kühlluft tritt von unten in den Innenraum des Schaltschranks ein und durchströmt diesen vertikal nach oben. Dadurch entsteht im Schaltschrank ein geschlossener Kühlluftkreislauf zur Abführung der von den Steckbaugruppen erzeugten Wärme. Die Kühlluft wird dabei von dem Lüfter im Dachraum des Schaltschranks angesaugt, wodurch die Luftzirkulation verbessert wird.

Der erfindungsgemäße Schaltschrank weist den Vorteil auf, dass beim Entstehen von Tropfwasser oder Kondenswasser am Wärmetauscher eine Beschädigung der elektronischen Steckbaugruppen ausgeschlossen ist, da der Wärmetauscher unterhalb der Baugruppen platziert ist. Gleichzeitig wird hierdurch die Zugänglichkeit des Wärmetauschers erhöht, da der Sockelraum bevorzugt separat zugänglich ist. Im Falle des Ausfallens oder der Beschädigung kann der Wärmetauscher aus dem Schranksockel entnommen werden, ohne dass ein Eingriff in den Schaltschrank, insbesondere in seinem Innenraum mit den elektronischen Steckbaugruppen notwendig ist. Ein Abschalten der elektronischen Baugruppen oder Geräte entfällt. Der Sockel kann beispielsweise als Schublade ausgebildet sein, wodurch die Zugänglichkeit des Wärmetauschers weiter erhöht wird.

Der im Dachraum des Schaltschranks angeordnete Lüfter verbessert die Luftdurchströmung des Schaltschranks wesentlich. Die Zirkulation innerhalb des Schaltschranks wird optimiert. Die angesaugte Warmluft wird direkt in den Luftkanal des Schaltschranks eingeblasen und dem Wärmetauscher zugeleitet, ohne dass es zu einem Luftstau oder zu einer Verringerung des Luftdurchflusses kommt. Eine Kondensatbildung am Dach des Schaltschranks ist ausgeschlossen, da die erwärmte Luft sofort in den Luftkanal weiterströmt und sich nicht im Dachraum niederschlägt.

Durch die Kombination des im Sockel angeordneten Wärmetauschers und des im Dachraum positionierten Lüfters wird eine Kondensatbildung oberhalb der Steckbaugruppen und damit eine mögliche Beschädigung der Steckbaugruppen durch herabtropfende Feuchtigkeit zuverlässig und auf einfache Weise ausgeschlossen.

Um die Luftführung innerhalb des Schaltschranks zu verbessern, können vorteilhafterweise mehrere Luftkanäle in dem Schaltschrank positioniert sein, um die erwärmte Luft vom Dachraum zum Wärmetauscher im Sockel zurückzuführen. Die Luftkanäle können an mehreren Seitenwänden ausgebildet sein. Auch kann ein Luftkanal (zusätzlich) in der Tür und/oder der Rückwand angeordnet sein. Wenn der Schaltschrank über eine vordere und eine rückwärtige Tür verfügt, ist es möglich in einer oder beiden Türen einen oder mehrere, vorzugsweise parallel verlaufende, Luftkanäle anzuordnen.

Die Luftkanäle an einer Seitenwand sind vorzugsweise voneinander beabstandet, so dass sich für jeden Kanal eine größere Wandungsfläche ergibt, die ihrerseits ebenfalls die Funktion eines Wärmetauschers übernehmen kann, insbesondere wenn eine Temperaturdifferenz zwischen der in den Kanal geführten Luft und der Umgebungsluft des Luftkanals im Innenraum besteht.

Ist die Lufttemperatur im Luftkanal geringer als die Umgebungstemperatur, so wird die Umgebung um den Luftkanal von der abwärts strömenden Luft im Luftkanal gekühlt. Der Luftkanal wirkt dann wie ein weiterer Wärmetauscher und kühlt die Steckbaugruppen zusätzlich zu dem durch den Innenraum strömenden Kühlluftstrom.

Bevorzugt ist bei der benachbarten Anordnung mehrerer Luftkanäle an einer Seite des Innenraums des Schaltschranks der Querschnitt jedes einzelnen Luftkanals groß genug, dass ein reibungsfreies Durchströmen der Luft vom Dachraum in den Sockelraum gewährt und ein Luftstau vermieden wird. Die Luftströmung ist bevorzugt laminar und frei von Turbulenzen.

Erfindungsgemäß ist der bzw. sind die Luftkanäle seitlich des Innenraums angeordnet. Zur Realisierung einer derartigen Anordnung bieten sich die folgenden Möglichkeiten:
1. Der Luftkanal ist bevorzugt an einer Außenwand des Schaltschranks angeordnet bzw. angeformt. Diese Ausführungsform wird insbesondere dann bevorzugt, wenn der Innenraum selbst über keine Seitenwände oder ähnliche großflächige Begrenzungsstücke verfügt. Der Luftkanal ist dann bevorzugt an der Innenseite der Außenwand des Schaltschranks angeformt und weist zum Innenraum des Schaltschranks hin. Da die Temperatur der in dem Luftkanal geführten Luft in der Regel niedriger ist als die Luft in unmittelbarer Umgebung der Steckbaugruppen, wirkt der Luftkanal gleichzeitig als Wärmetauscher. Hierdurch werden die Steckbaugruppen zusätzlich gekühlt, was die Effizienz des gesamten Kühlkreislaufs erhöht.
2. Wenn der Innenraum des Schaltschranks selbst über zusätzliche Seitenwände verfügt, kann der Luftkanal auch an der Seitenwand des Innenraums ausgebildet sein. Der Luftkanal kann wahlweise an der Innenseite und/oder an der Außenseite der Außenwand angeordnet sein.
3. In Fällen, in denen sowohl der Innenraum als auch der Schaltschrank eine seitliche Wand aufweisen, beispielsweise wenn erhöhte Anforderungen an die elektrische Schirmwirkung gegeben sind, kann der Zwischenraum zwischen der Seitenwand des Innenraums und der Außenwand des Schaltschranks als Luftkanal genutzt werden. Bevorzugt ist dieser Zwischenraum in Vertikalrichtung unterteilt, so dass mehrere benachbarte Luftkanäle gebildet werden.
   Die Unterteilungen, die beispielsweise als Trennbleche ausgebildet sein können, sind bevorzugt mit beiden Wänden fest verbunden, vorzugsweise verschweißt und dienen gleichzeitig zur Versteifung des Schranks bzw. der Seitenwände.

Besonders bevorzugt wird der Luftkanal durch Versteifungsteile der Wand des Innenraums gebildet. Diese Versteifungsteile, die beispielsweise aus trapez- oder rechteckförmigen, sich vertikal erstreckenden Blechen gebildet werden, sind mit der Wand verbunden und erhöhen deren Steifigkeit. Die Verbindung kann entweder lösbar, beispielsweise durch mehrere Schrauben, oder fest bzw. einstückig sein, beispielsweise wenn Blech und Wand miteinander verwalzt oder verschweißt sind. Bevorzugt ist die Verbindung der Versteifungsbleche mit der Wand derart großflächig, dass die Luft nicht an oder zwischen den Verbindungsstellen aus dem Luftkanal entweichen kann sondern vollständig in den Luftkanal geführt wird.

Insbesondere bei der Ausbildung der Luftkanäle in Türen erweist sich ihre Anordnung an der Außenwand der Tür als besonders vorteilhaft. Nach Öffnen der Tür ist der Innenraum dann direkt zugänglich.

In einer bevorzugten Ausführungsform ist der Lüfter im Dachraum des Schaltschranks als Radiallüfter ausgebildet. Der Radiallüfter weist an seiner Unterseite einen Lufteinlass auf, der in Richtung Innenraum des Schaltschranks gerichtet ist. Ein Luftauslass des Radiallüfters ist in Richtung auf den Luftkanal orientiert, so dass die aus dem Innenraum angesaugte Luft direkt in Richtung Luftkanal bewegt wird.

Vorzugsweise weist der Lüfter wenigstens zwei seitliche Luftauslässe auf, die in Richtung von wenigstens zwei Luftkanälen gerichtet sind. Insbesondere wenn je ein Luftkanal an den gegenüberliegenden Seitenwänden angeordnet ist, ist ein Radiallüfter mit zwei gegenüberliegenden Luftauslässen bevorzugt, die jeweils in Richtung Seitenwand orientiert sind. Sind Luftkanäle an allen Seitenwänden und der Tür vorhanden, ist der Radiallüfter bevorzugt seitlich offen, so dass die angesaugte Luft in alle Winkelrichtungen radial nach außen geblasen wird, um in die entsprechenden Luftkanäle einzuströmen.

In einer weiter bevorzugten Ausführungsform des erfindungsgemäßen Schaltschranks sind mehrere Lüfter im Dachraum des Schaltschranks angeordnet. Die Lüfter sind vorzugsweise über der Grundfläche des Innenraums gleichmäßig verteilt. Insbesondere bietet sich der Einsatz von vier oder von neun rechteckig bzw. quadratisch angeordneten Lüftern an. Die Verwendung mehrerer kleinerer Lüfter hat zum einen den Vorteil, dass auch beim Ausfall eines Lüfters immer noch ein genügend hoher Luftdurchsatz realisiert wird, so dass eine Überhitzung der elektronischen Steckbaugruppen oder Module zuverlässig verhindert wird. Zum anderen ist die Bauhöhe kleinerer Lüfter oft reduziert, so dass die Lüfter in der Regel auch problemlos nachgerüstet werden können.

Bevorzugte Ausführungsformen werden anhand der Figuren näher erläutert. Die dort dargestellten Besonderheiten können einzelnen oder in Kombination verwendet werden, um bevorzugte Ausgestaltungen der Erfindung zu schaffen. Die dargestellten Ausführungen stellen jedoch keine Einschränkung der durch die Patentansprüche definierten Erfindung dar. Es zeigen:
- Figur 1: Einen Frontalschnitt eines erfindungsgemäßen Schaltschranks zur Aufnahme von Steckbaugruppen;
- Figur 2: eine Seitenansicht des Schaltschranks aus Figur 1;
- Figur 3a: eine Draufsicht auf den Schaltschrank aus Figur 1 mit einem Lüfter im Dachraum des Schaltschranks;
- Figur 3b: eine alternative Ausführungsform eines Schaltschranks mit zwei im Dachraum angeordneten Lüftern; und
- Figur 4: ein Schnittbild durch eine Seitenwand des Schaltschranks aus Figur 1.

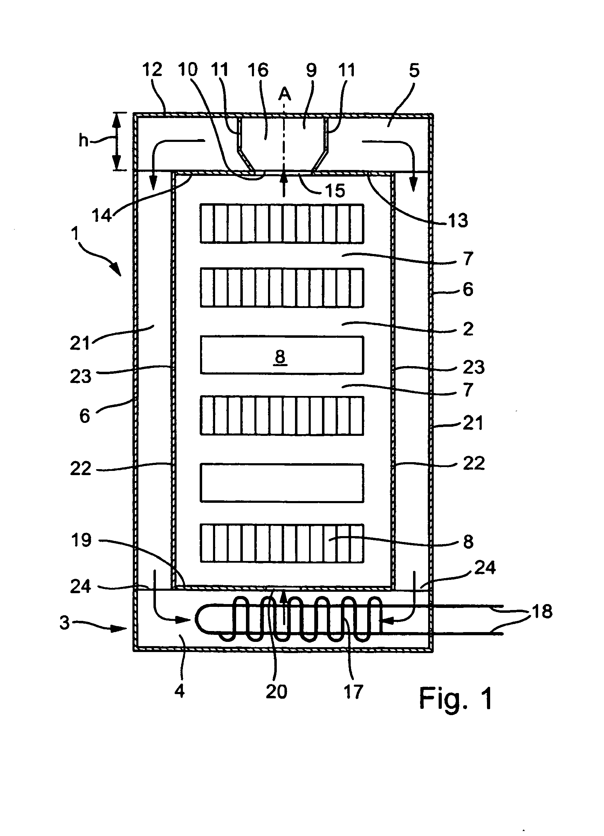

Figur 1 zeigt einen Schaltschrank 1 zur Aufnahme von elektronischen Steckbaugruppen im Schnitt. Der Schaltschrank 1 umfasst einen Innenraum 2, einen unterhalb des Innenraums 2 angeordneten Sockel 3, der einen Sockelraum 4 bildet, und einen Dachraum 5, der oberhalb des Innenraums 2 angeordnet ist. Der Schaltschrank 1 wird von zwei sich vertikal erstreckenden Außenwänden 6 begrenzt.

Im Innenraum 2 sind in mehreren übereinander geordneten Ebenen 7 Steckbaugruppen 8 gelagert. Die Steckbaugruppen 8 einer Ebene 7 sind derart voneinander beabstandet, dass ein vertikaler Luftstrom zwischen ihnen hindurchgeführt werden kann. Die Steckbaugruppen 8 weisen an ihrer Vorderseite jeweils eine Frontplatte auf, die bündig miteinander abschließen. Die Steckbaugruppen 8 sind in den einzelnen Ebenen 7 in Führungsschienen verschiebbar gelagert, die sich horizontal erstrecken.

In dem Dachraum 5 oberhalb des Innenraums 2 ist ein Lüfter 9 angeordnet, der Luft aus dem Innenraum 2 ansaugt. Der Lüfter 9 hat einen Lufteinlass 10, der in Richtung Innenraum 2 orientiert ist. An seinen Außenseiten weist er zwei gegenüberliegende Luftauslässe 11 auf, die zu den Außenwänden 6 des Schaltschranks 1 hin ausgerichtet sind. Der bevorzugt als Radiallüfter 16 ausgebildete Lüfter 9 hat mehrere Lüfterschaufeln, die sich um eine vertikale Längsachse A drehen.

Der Dachraum 5 wird nach oben hin von einem Dach 12 und nach unten durch eine Deckplatte 13 begrenzt, die eine Trennwand 14 zwischen dem Dachraum 5 und dem Innenraum 2 bildet und beide voneinander trennt. Diese Anordnung mit der Trennwand 14 bietet den Vorteil, dass der Innenraum 2 auch dann von oben verschlossen ist, wenn der Dachraum 5 geöffnet wird, beispielsweise in dem das Dach 12 für Reparaturzwecke oder Wartungsarbeiten am Lüfter 9 entfernt wird.

In dieser bevorzugten Ausführungsform, in der der Innenraum 2 und der Dachraum 5 durch eine Trennwand 14 voneinander getrennt sind, weist die Trennwand 14 vorteilhafterweise eine Durchtrittsöffung 15 für die Luft auf, oberhalb der der Lüfter 9 angeordnet ist. Die Durchtrittsöffung 15 ist derart ausgebildet, dass sie mit dem Lufteinlass 10 korrespondiert. Der Lufteinlass 10 schließt sich bündig an die Durchtrittsöffung 15 an, so dass nur Luft aus dem Innenraum 2 und nicht aus dem Dachraum 5 angesaugt wird. Alternativ kann zwischen dem Lufteinlass 10 und der Durchtrittsöffung 15 ein Luftstutzen vorgesehen sein, wenn der Lufteinlass 10 von der Trennwand 14 beabstandet ist. Vorteilhafterweise ist die Durchtrittsöffung 15 deshalb kreisförmig, wobei der Mittelpunkt der Durchtrittsöffung 15 mit der Achse A des Radiallüfters 16 fluchtet.

Die Verwendung eines Radiallüfters 16 hat sich als besonders vorteilhaft erwiesen, da der Radiallüfter von sich aus eine 90-Grad-Umlenkung des Luftstroms erzeugt. Somit kann die gesamte zur Verfügung stehende Dachhöhe h des Dachraums 5 ausgenutzt werden. Andererseits kann die Dachhöhe an die relativ geringe Bauhöhe des Radiallüfters 16 angepasst werden, was zu einer Vergrößerung des Innenraums 2 bei konstanter Schrankhöhe führt.

Alternativ zu einem Radiallüfter 16 kann natürlich auch ein Axial- oder Diagonallüfter eingesetzt werden. In diesem Fall muss die senkrecht aus dem Innenraum 2 herausgesaugte Luft im Dachraum 5 umgelenkt werden, so dass sie zu den Außenwänden 6 geführt wird.

Vorteilhafterweise ist der Dachraum 5 von außen zugänglich, ohne dass der Innenraum 2 des Schaltschranks 1 geöffnet werden muss. Ein Betrieb der Steckbaugruppen 8 ist auch dann möglich, wenn der Dachraum 5 geöffnet wird, beispielsweise um den Lüfter 9 auszutauschen oder zu reparieren. Der Zugang des Dachraums ist bevorzugt an der Frontseite und/oder der Rückseite des Schranks vorgesehen.

Vorteilhafterweise umfasst der Innenraum 2 am unteren Ende einen Boden 19, der ihn von dem Sockelraum 4 trennt. Der Boden 19 ist für Kühlluft durchlässig. Bevorzugt weist er dazu wenigstens eine Öffnung 20 auf, durch die Kühlluft aus dem Sockelraum 4 in den Innenraum 2 eintreten kann. Im Sockelraum 4 ist ein Luft-Wasser-Wärmetauscher 17 angeordnet, der über zwei Wasseranschlüsse 18 an einen Kaltwasserkreislauf angeschlossen ist. Der Wärmetauscher 17 ist bevorzugt direkt unterhalb der Öffnung 20 platziert. Alternativ zu einer einzelnen Öffnung 20 können auch mehrere Öffnungen vorgesehen sein. Beispielsweise kann der Boden 19 perforiert sein und eine große Anzahl von kleineren Öffnungen, vorzugsweise runden oder quadratischen Löchern, aufweisen. Die Anzahl und Größe der Öffnungen 20 sowie deren Ausbildung und Form ergibt sich aus einer strömungstechnischen Optimierung. Die Öffnungen 20 sind derart ausgestaltet, dass keine turbulente Strömung an den Kanten der Öffnungen 20 entsteht.

In einer bevorzugten Ausführungsform kann die Lufteintrittsöffnung 20 im Boden 19 des Innenraums 2 derart ausgebildet sein, dass sie nahezu die gesamte Fläche des Bodens 19 einnimmt, so dass eine rahmenähnliche Bodenanordnung entsteht. Besonders bevorzugt ist die Öffnung 20 am Boden 19 jedoch an den Wärmetauscher 17 im Sockelraum 4 angepasst, so dass die gesamte Kühlluft erst den Wärmetauscher 17 umströmt und dann durch die Öffnung 20 in den Innenraum 2 eintritt.

Die Außenwände 6 weisen einen Luftkanal 21 auf, der sich vertikal erstreckt und den Sockelraum 4 mit dem Dachraum 5 verbindet. Der Luftkanal 21 wird aus der Außenwand 6 und einem Versteifungsteil 23 gebildet, welches die Außenwand 6 stabilisiert und versteift. Das Versteifungsteil 23 ist mit der Außenwand 6 derart verbunden, dass es seitlich fest und dichtend abschließt, so dass der Luftstrom innerhalb des Luftkanals 21 geführt wird.

Die von den Steckbaugruppen 8 im Innenraum 2 erzeugte Wärme wird an die Umgebung im Innenraum 2 abgegeben. Die entstehende Warmluft wird von dem Radiallüfter 16 im Dachraum 5 angesaugt und aus den Luftauslässen 11 entlang des Dachs 12 zu den Luftkanälen 21 in den Außenwänden 6 umgelenkt. Die Warmluft strömt dann durch die Luftkanäle 21 an den Außenwänden 6 vom Dachraum 5 hinunter und tritt durch Luftkanalaustrittsöffnungen 24 in den Sockelraum 4 ein. Dort wird sie an dem Wärmetauscher 17 vorbeigeführt, wobei die erwärmte Luft abgekühlt wird. Die entstehende Kühlluft wird durch die Öffnungen 20 in den Innenraum 2 abgegeben. Die Konvektion wird durch den Lüfter 9 im Dachraum 5 unterstützt, so dass die Kühlluft den Innenraum 2 vertikal nach oben in Richtung Dachraum 5 durchströmt und dabei an den Steckbaugruppen 8 entlang geführt wird und diese kühlt.

Dadurch entsteht ein geschlossener Kühlluftkreislauf, der die von den Steckbaugruppen 8 erzeugte Wärme abführt. Gleichzeitig dienen die aus den Versteifungsteilen 23 gebildeten Innenwände 22 der Luftkanäle 21 ebenfalls als Wärmetauscher. Da die in den Luftkanälen 21 vom Dachraum 5 zum Sockelraum 4 geführte Luft kühler ist als die von den Steckbaugruppen 8 direkt abgegebene Warmluft trägt die Innenwand 22 zusätzlich zur Kühlung der Steckbaugruppen 8 bei.

In Figur 1 sind zwei entscheidende Vorteile dieser Ausführungsform zu erkennen. Zum einen tropft Kondenswasser, das sich am Wärmetauscher 17 bildet, im Sockelraum 4 nach unten und kann nicht an die Steckbaugruppen 8 oder andere im Innenraum 2 gelagerte elektronische Einheiten gelangen. Zum anderen wird die in den Dachraum 5 geführte Warmluft zuverlässig von dem Lüfter 9 in den Luftkanal 21 bewegt. Ein Luftstau im Dachraum 5 wird verhindert, so dass auf einfache Weise jede Art der Kondensbildung am Dach 12 zuverlässig vermieden wird. Darüber hinaus dient der Luftkanal 21 zusätzlich als Wärmetauscher und trägt ebenfalls zur Kühlung des Innenraums 2 bei.

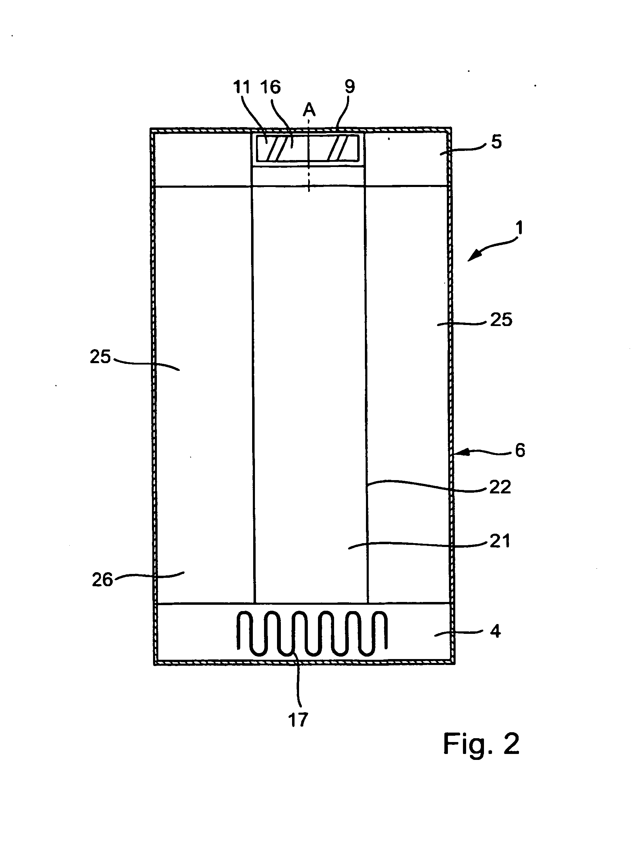

In Figur 2 ist ein seitlicher Schnitt durch den Luftkanal 21 an der Außenwand 6 des Schaltschranks 1 gezeigt. Der in der Mitte der Außenwand 6 vertikal verlaufende Luftkanal 21 wird von der Außenwand 6 und einer Innenwand 22 gebildet. An beiden Seiten des Luftkanals 21 ist an der Außenwand 6 jeweils ein Bereich 25 benachbart, in dem die Verkabelungen für die Steckbaugruppen 8 verlaufen. Die Bereiche 25 sind jeweils als Kabelkanal 26 ausgebildet, in den die Signal- und Versorgungsleitungen geführt werden. Auf Grund der beiden Kabelkanäle 26 ist auch eine Trennung der Versorgungsleitungen von den Signalleitungen möglich.

Oberhalb des Luftkanals 21 ist im Dachraum 5 der Radiallüfter 16 angeordnet. Seine Drehachse fluchtet mit der Mittellinie des Luftkanals 21. Der Radiallüfter 16 hat einen Luftauslass 11, der zum Luftkanal 21 hinorientiert ist. Die vom Lüfter angesaugte Warmluft wird zum Luftkanal 21 geblasen und dann in ihm vertikal nach unten geführt.

In Figur 2 ist auch zu erkennen, dass der Dachraum 5 und der Innenraum 2 durch die Trennwand 14 getrennt sind. Die Trennwand 14 hat eine (nicht dargestellte) Durchtrittsöffnung 15, an der der Lufteinlass des Radiallüfters 16 bündig anliegt. Die gesamte aus dem Innenraum 2 angesaugte Luft wird folglich durch den Radiallüfter 16 geleitet. In einer weiteren bevorzugten Ausführungsform kann die Trennwand 14 derart geneigt sein, dass sie zu den Außenseiten leicht abfällt. Dies ist insbesondere dann möglich, wenn der verwendete Radiallüfter 16 eine geringere Bauhöhe hat als die Höhe des Dachraums 5 hat. Bei einer geneigten Trennwand 14 wird der Luftstrom und die Luftzirkulation im Innenraum 2 weiter optimiert.

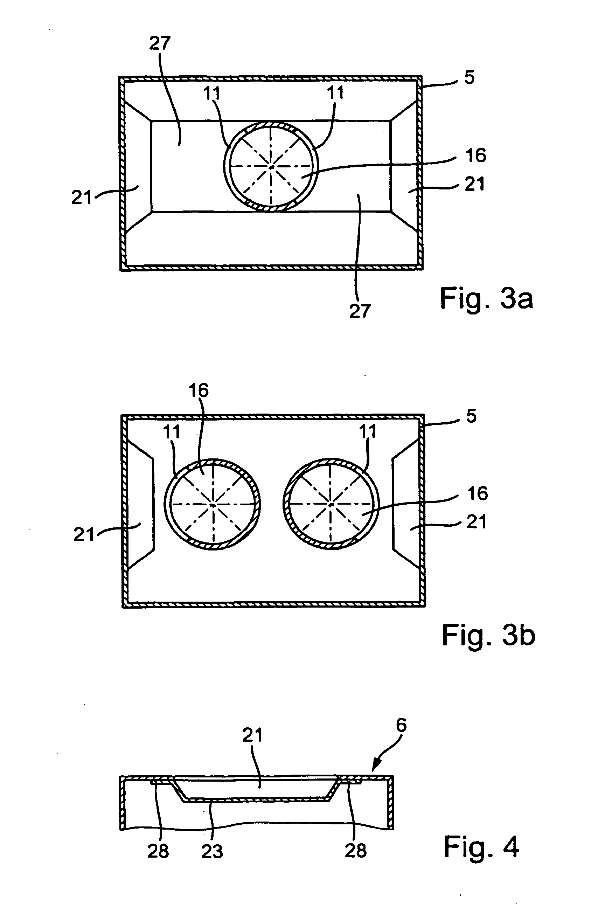

Die Figuren 3a und 3b zeigen eine Draufsicht auf den Dachraum 5 mit abgenommenem Dach 12. In Figur 3a ist eine Ausführungsform zu sehen, bei der ein Radiallüfter 16 verwendet wird. Die von unten in den Lüfter 9 eintretende Warmluft wird an den beiden Luftauslässen 11 in Richtung der zwei gegenüberliegenden Luftkanälen 21 geleitet. Dabei wird die Luft in einem Luftführungskanal 27 bewegt, der den Radiallüfter 16 mit den Luftkanälen 21 verbindet. Der Lüfter 9 ist mittig im Luftführungskanal 27 angeordnet. Die Luft wird im Dachraum 5 ausschließlich durch den Luftführungskanal 27 geleitet, so dass eine optimierte Luftströmung entsteht und jegliche Kondensbildung im Dach verhindert wird.

In Figur 3b ist eine Ausführungsform mit zwei Radiallüftern 16 im Dachraum 5 gezeigt. Jeder Lüfter ist in der Nähe des zugehörigen Luftkanals 21 angeordnet. Der Luftauslass 11 der Radiallüfter 16 ist jeweils zum Luftkanal 21 hin gerichtet. Die aus dem Innenraum 2 angesaugte Luft wird direkt in den Luftkanal 21 eingeblasen und in Richtung Sockelraum 4 bewegt. Im Dach kann zusätzlich ein Luftführungskanal 27 zwischen Lüfter 9 und Luftkanal 21 ausgebildet sein.

Der Luftauslass 11 ist an den Luftkanal 21 angepasst. Abhängig vom Abstand des Radiallüfters 16 vom Luftkanal 21 und von der Breite des Luftkanals 21 ist der Luftauslass 11 dimensioniert. In dem in Figur 3b dargestellten Beispiel entspricht die Breite des Luftauslasses 11 etwa einem Viertelkreis. Bei schmäleren Luftkanälen ist die Luftauslassöffnung entsprechend geringer; gleiches gilt, wenn der Abstand von Radiallüfter 16 zum Luftkanal 21 größer ist.

Neben der Ausführungsform mit zwei Radiallüftern nach Figur 3b können auch mehrere kleinere Lüfter vorgesehen sein. Diese sind dann vorzugsweise quadratisch oder rechteckig angeordnet. Auf einen Luftführungskanal kann in diesem Fall verzichtet werden.

Figur 4 zeigt die Außenwand 6 im Querschnitt. Deutlich zu erkennen ist der aus dem Versteifungsteil 23 und der Außenwand 6 gebildete Luftkanal 21. Das Versteifungsteil 23 ist ein sich über die gesamte Höhe der Außenwand 6 erstreckendes Blech, dessen Anlageschenkel 28 parallel zur Außenwand 6 verlaufen. Das Versteifungsteil 23 ist an den Anlageschenkel 28 mit der Innenseite der Außenwand 6 verschweißt. Hierdurch erfährt die Außenwand 6 eine zusätzliche Steifigkeit. Dies hat den Vorteil, dass für die Außenwand 6 relativ dünne Bleche verwendet werden können. Je nach Material der Außenwand und des Versteifungsteils ist eine entsprechende Befestigung zu wählen. Beispielsweise eignet sich ein Verkleben oder eine Befestigung durch Nieten oder Schrauben, um eine dauerhafte Verbindung zu schaffen. Es können selbstverständlich auch andere, dem Fachmann bekannte Arten der Verbindung und Befestigung gewählt werden.

## Patentansprüche

1. Schaltschrank zur Aufnahme elektronischer Steckbaugruppen, umfassend
- einen Innenraum (2), in dem die Steckbaugruppen (8) übereinander einbringbar sind,
- einen Dachraum (5), der oberhalb des Innenraums (2) angeordnet ist,
- einen Sockel (3) mit einem unterhalb des Innenraums (2) angeordneten Sockelraum (4), der mit dem Innenraum (2) in Verbindung steht,
- einen Luftkanal (21), der seitlich des Innenraums (2) angeordnet ist und den Dachraum (5) mit dem Sockelraum (4) verbindet,
- einen Lüfter (9), der im Dachraum (5) angeordnet ist und Luft (Kühlluft) aus dem Innenraum (2) ansaugt und durch den Luftkanal (21) in den Sockelraum (4) fördert, so dass ein geschlossener Kühlluftkreislauf zur Abführung der von den Steckbaugruppen (8) erzeugten Wärme aus dem Innenraum (2) entsteht, wobei die Kühlluft den Innenraum (2) von unten nach oben vertikal durchströmt,
- einen Wärmetauscher (17), der im Sockelraum (4) angeordnet ist und die Kühlluft abkühlt.

2. Schaltschrank nach Anspruch 1, **dadurch gekennzeichnet, dass** zwischen dem Innenraum (2) und dem Sockelraum (4) ein Boden (19) vorgesehen ist, der für Kühlluft durchlässig ist.

3. Schaltschrank nach Anspruch 1 oder 2, **dadurch gekennzeichnet, dass**
- der Innenraum (2) und der Dachraum (5) durch eine Trennwand (14) voneinander getrennt sind, und
- die Trennwand (14) eine Durchtrittsöffnung (15) aufweist, oberhalb der der Lüfter (9) angeordnet ist.

4. Schaltschrank nach Anspruch 3, **dadurch gekennzeichnet, dass** der Lüfter einen Lüftereinlass (10) aufweist, der mit der Durchtrittsöffnung (15) der Trennwand (14) derart in Verbindung steht, dass Luft ausschließlich aus dem Innenraum (2) angesaugt wird.

5. Schaltschrank nach einem der vorhergehenden Ansprüche, **dadurch gekennzeichnet, dass** der Luftkanal (21) an einer Seitenwand des Innenraums (2) ausgebildet ist.

6. Schaltschrank nach einem der Ansprüche 1 bis 3, **dadurch gekennzeichnet, dass** der Luftkanal (21) an einer Außenwand (6) des Schaltschranks (1) angeformt ist.

7. Schaltschrank nach Anspruch 5 oder 6, **dadurch gekennzeichnet, dass** der Luftkanal (21) von Versteifungsteilen (23) gebildet wird, die sich an einer der Wände (6) des Schaltschranks (1) erstrecken.

8. Schaltschrank nach einem der Ansprüche 1 bis 4, **dadurch gekennzeichnet, dass** der Luftkanal (21) zwischen der Seitenwand des Innenraums (2) und der Außenwand (6) des Schaltschranks (1) gebildet wird.

9. Schaltschrank nach einem der vorhergehenden Ansprüche, **dadurch gekennzeichnet, dass** mehrere Luftkanäle (21) in dem Schaltschrank (1) ausgebildet sind.

10. Schaltschrank nach einem der vorhergehenden Ansprüche, **dadurch gekennzeichnet, dass** der Lüfter (9) ein Radiallüfter (16) ist und einen seitlichen in Richtung auf den Luftkanal (21) zu gerichteten Lüfterauslass (11) hat, bevorzugt wenigstens zwei Lüftauslässe (11) hat, besonders bevorzugt seitlich offen ist.

## Claims

1. A control cabinet for electronic plug-in assemblies including
- an interior space (2), in which the plug-in assemblies (8) may be placed above one another,
- a roof space (5), which is disposed above the interior space (2),
- a base (3) with a base space (4), which is disposed below the interior space (2) and is in communication with the interior space (2),
- an air passage (21), which is disposed laterally of the interior space (2) and connects the roof space (5) to the base space (4),
- a fan (9), which is arranged in the roof space (5) and draws air (cooling air) from the interior space (2) and conveys it through the air passage (21) into the base space (4) so that a closed cooling air circuit is produced for conducting heat generated by the plug-in assemblies (8) out of the interior space (2), whereby the cooling air flows upwardly through the interior space (2),
- a heat exchanger (17), which is arranged in the base space (4) and cools the cooling air.

2. A control cabinet as claimed in Claim 1, **characterised in that** a floor (19), which is permeable to cooling air, is provided between the interior space (2) and the base space (4).

3. A control cabinet as claimed in Claim 1 or 2, **characterised in that**
- the interior space (2) and the roof space (5) are separated from one another by a partition wall (14), and
- the partition wall (14) has a flow opening (15), above which is arranged the fan (9).

4. A control cabinet as claimed in Claim 3, **characterised in that** the fan has a fan inlet (10), which communicates with the flow opening (15) in the partition wall (14) such that air is drawn exclusively out of the interior space (2).

5. A control cabinet as claimed in one of the preceding claims, **characterised in that** the air passage (21) is defined at a side wall of the interior space (2).

6. A control cabinet as claimed in one of Claims 1 to 3, **characterised in that** the air passage (21) is formed on an outer wall (6) of the control cabinet (1).

7. A control cabinet as claimed in Claim 5 or 6, **characterised in that** the air passage (21) is defined by stiffening components (23), which extend on one of the walls (6) of the control cabinet (1).

8. A control cabinet as claimed in one of Claims 1 to 4, **characterised in that** the air passage (2) is defined between the side wall of the interior space (2) and the outer wall (6) of the control cabinet (1).

9. A control cabinet as claimed in one of the preceding claims, **characterised in that** a plurality of air passages (21) are defined in the control cabinet (1).

10. A control cabinet as claimed in one of the preceding claims, **characterised in that** the fan (9) is a radial fan (16) and has a lateral fan outlet (11) aligned in the direction towards the air passage (21), preferably at least two air outlets (11), and is particularly preferably laterally open.

## Revendications

1. Armoire électrique pour la réception de modules enfichables électroniques, comprenant
- un espace intérieur (2), dans lequel les modules enfichables (8) peuvent être mis en place les uns au-dessus des autres,
- un espace de toit (5) disposé au-dessus de l'espace intérieur (2),
- un socle (3) avec un espace de socle (4), disposé au-dessous de l'espace intérieur (2) et relié à l'espace (2),
- un canal d'air (21), qui est disposé à côté de l'espace intérieur (2) et relie l'espace de toit (5) à l'espace de socle (4),
- un ventilateur (9), qui est disposé dans l'espace de toit (5), aspire de l'air (air de refroidissement) de l'espace intérieur (2) et le refoule dans l'espace de socle (4) au travers du canal d'air (21), de sorte qu'il se forme un circuit d'air de refroidissement fermé pour dissiper de l'espace intérieur (2) la chaleur produite par les modules enfichables (8), l'air de refroidissement balayant verticalement l'espace intérieur (2) du bas vers le haut,
- un échangeur de chaleur (17), qui est disposé dans l'espace de socle (4) et refroidit l'air de refroidissement.

2. Armoire électrique suivant la revendication 1, **caractérisée en ce qu'**il est prévu un fond (19), perméable à l'air de refroidissement, entre l'espace intérieur (2) et l'espace de socle (4).

3. Armoire électrique suivant l'une des revendications 1 et 2, **caractérisée en ce que**
- l'espace intérieur (2) et l'espace de toit (5) sont séparés l'un de l'autre par une cloison (14), et
- la cloison (14) présente une ouverture de passage (15), au-dessus de laquelle est disposé le ventilateur (9).

4. Armoire électrique suivant la revendication 3, **caractérisée en ce que** le ventilateur présente une admission d'air (10), qui est en liaison avec l'ouverture de passage (15) de la cloison (14) de telle sorte que de l'air est aspiré exclusivement de l'espace intérieur (2).

5. Armoire électrique suivant l'une des revendications précédentes, **caractérisée en ce que** le canal d'air (21) est réalisé sur une paroi latérale de l'espace intérieur (2).

6. Armoire électrique suivant l'une des revendications 1 à 3, **caractérisée en ce que** le canal d'air (21) est conformé sur une paroi extérieure (6) de l'armoire électrique (1).

7. Armoire électrique suivant l'une des revendications 5 et 6, **caractérisée en ce que** le canal d'air (21) est formé de raidisseurs (23), qui s'étendent sur l'une des parois (6) de l'armoire électrique (1).

8. Armoire électrique suivant l'une des revendications 1 à 4, **caractérisée en ce que** le canal d'air (21) est formé entre la paroi latérale de l'espace intérieur (2) et la paroi extérieure (6) de l'armoire électrique (1).

9. Armoire électrique suivant l'une des revendications précédentes, **caractérisée en ce que** plusieurs canaux d'air (21) sont réalisés dans l'armoire électrique (1).

10. Armoire électrique suivant l'une des revendications précédentes, **caractérisée en ce que** le ventilateur (9) est une soufflante radiale (16) et présente un échappement (11) latéral orienté en direction du canal d'air (21), de préférence au moins deux échappements d'air (11), de manière particulièrement préférée ouvert latéralement.
